# EUROPEAN PATENT APPLICATION

(11) **EP 4 318 796 A1**
(43) Date of publication of application: **07.02.2024**
(21) Application number: 22787582.0
(22) Date of filing: 13.04.2022
(51) Int. Cl.: H01P 5/10, H01P 5/107, H01P 11/00, H01Q 13/06, H01Q 1/27, H01Q 1/28, H01Q 1/32, H05K 1/02, H05K 3/06, G01S 7/02

(54) **COUPLING DEVICE, MANUFACTURING METHOD, WAVEGUIDE ANTENNA, RADAR, TERMINAL, AND PCB**

(30) Priority: 14.04.2021 CN 202110400748
(71) Applicant: Huawei Technologies Co., Ltd., Longgang Shenzhen, Guangdong 518129 (CN)
(72) Inventor: TANG, Chuankang, Shenzhen, Guangdong 518129 (CN); ZHOU, Yuxiang, Shenzhen, Guangdong 518129 (CN); YANG, Xiaopan, Shenzhen, Guangdong 518129 (CN); TAO, Jun, Shenzhen, Guangdong 518129 (CN)
(74) Representative: Goddar, Heinz J.
(86) International application number: PCT/CN2022/086701
(87) International publication number: WO 2022/218360

(57) **Abstract**

A coupling apparatus and a manufacturing method, a waveguide antenna, a radar, a terminal, and a PCB are disclosed. The coupling apparatus includes a PCB and a waveguide. The PCB has at least one switching area, a microstrip coupling patch is disposed in each switching area, and each microstrip coupling patch is provided with a coupling gap. The PCB is further provided with a microstrip, and each microstrip coupling patch is connected to the microstrip. The waveguide has a waveguide cavity, and the waveguide cavity includes a coupling port corresponding to the switching area. For the corresponding coupling port and the switching area, an overlapping area exists between a vertical projection of each coupling port on the PCB and the switching area, and the vertical projection of each coupling port on the PCB covers the microstrip coupling patch in the switching area. The apparatus couples energy by using the microstrip coupling patch, so that energy transmission between the PCB and the waveguide can be implemented. In addition, the microstrip coupling patch in the coupling apparatus is provided with the coupling gap, so that transfer performance of the apparatus can be improved and bandwidth can be expanded.

## Description

### CROSS-REFERENCE TO RELATED APPLICATIONS

This application claims priority to Chinese Patent Application No. 202110400748.0, filed with the China National Intellectual Property Administration on April 14, 2021 and entitled "COUPLING APPARATUS AND MANUFACTURING METHOD, WAVEGUIDE ANTENNA, RADAR, TERMINAL, AND PCB", which is incorporated herein by reference in its entirety.

### TECHNICAL FIELD

This application relates to the field of antenna technologies, and in particular, to a coupling apparatus and a manufacturing method, a waveguide antenna, a radar, a terminal, and a PCB.

### BACKGROUND

Antennas used in an existing terminal are mainly classified into a printed circuit board (printed circuit board, PCB) antenna and a waveguide antenna. The PCB antenna is an antenna that guides radio frequency energy from an air medium to a PCB, and the waveguide antenna is an antenna that guides radio frequency energy from an air medium to a waveguide. It should be noted that the waveguide antenna has higher radiation efficiency, wider operating frequency band, better spurious radiation shielding, and better heat conduction capability than the PCB antenna, and is a potential high-performance automotive antenna solution. In addition, because processing costs of the waveguide antenna after precision injection molding and electroplating is low, the waveguide antenna is one of the development trends of a millimeter wave vehicle-mounted antenna in the future.

Transfer between a PCB and a waveguide in the waveguide antenna is a key point. In an existing transfer solution, one manner is to transfer by using a back cavity structure, and another manner is to transfer by using a conventional PCB pattern, to implement energy transmission between the waveguide and the PCB. In a solution in which the back cavity structure is used for transfer, a Z-direction size of a back cavity is large, so that it is difficult to process the waveguide antenna. In a solution in which a PCB pattern is used for transfer, bandwidth is narrow, and transfer performance is average.

Therefore, how to provide a coupling apparatus that is easy to manufacture and has excellent transfer performance is an urgent problem to be resolved.

### SUMMARY

This application provides a coupling apparatus and a manufacturing method, a waveguide antenna, a radar, a terminal, and a PCB, to provide a coupling apparatus that is easy to manufacture and has excellent transfer performance.

According to a first aspect, this application provides a coupling apparatus. The coupling apparatus includes a printed circuit board (printed circuit board, PCB) and a waveguide. The PCB has at least one switching area, a microstrip coupling patch is disposed in each switching area, the PCB is further provided with a microstrip, and each microstrip coupling patch is connected to the microstrip. The waveguide has a waveguide cavity, and the waveguide cavity includes a coupling port that corresponds to the switching area and is configured to implement an electromagnetic signal conversion function. It should be understood that the coupling port of the waveguide cooperates with the switching area on the PCB, to implement conversion of an electromagnetic signal between the PCB and the waveguide. Specifically, when an electromagnetic signal on the PCB is transmitted, through the microstrip, to the microstrip coupling patch connected to the microstrip, the microstrip coupling patch is coupled to the coupling port through the microstrip coupling patch and a coupling gap, to convert the electromagnetic signal into an electromagnetic signal that can be transmitted in the waveguide. Then, the converted electromagnetic signal is transmitted in the waveguide, and is radiated to space through the waveguide. On the contrary, the electromagnetic signal in the waveguide may be converted, in the switching area, into an electromagnetic signal that can be transmitted in the microstrip, and then the converted electromagnetic signal is transmitted in the microstrip.

According to the coupling apparatus provided in this application, energy is coupled by using the microstrip coupling patch, so that energy transmission between the PCB and the waveguide can be implemented. The microstrip coupling patch is provided with the coupling gap, so that transfer performance of the coupling apparatus can be improved and bandwidth can be expanded. In addition, compared with the conventional technology, removing a metal back cavity structure not only enable the coupling apparatus provided in this application to have an advantage of good sizes in various directions, but also simplify a manufacturing process. During disposition, it should be noted that an overlapping area exists between a vertical projection of each coupling port on the PCB and the switching area corresponding to the coupling port, and the vertical projection of each coupling port on the PCB covers the microstrip coupling patch in the switching area corresponding to the coupling port, to improve a transfer effect of the coupling apparatus provided in this application.

When the coupling apparatus provided in this application is specifically disposed, an impedance transition section may be disposed in the switching area. The impedance transition section is connected to the microstrip coupling patch in the switching area and the microstrip on the PCB, to adjust impedance during energy transmission between the PCB and the waveguide. For example, the impedance transition section is transitionally connected to the microstrip coupling patch and the microstrip. It should be understood that the impedance transition section may be disposed in each switching area, or the impedance transition section may be disposed in only some switching areas.

In addition, when the coupling apparatus provided in this application is specifically disposed, to improve a capability of an alignment tolerance between the PCB and the waveguide in the coupling apparatus, the vertical projection of each coupling port on the PCB is in the switching area corresponding to the coupling port. Specifically, a size of the switching area is greater than a size of the coupling port, so that an alignment tolerance between the PCB and the waveguide at a transfer position can be improved. This reduces impact of an alignment error on transfer performance.

For example, when the coupling gap on each microstrip coupling patch is specifically set, the coupling gap may be set to a U-shaped groove. Certainly, the coupling gap may also be H-shaped, straight-shaped, or a triangle, and may be specifically set according to a use requirement. Details are not described herein again. For example, when the coupling gap is a U-shaped groove and the microstrip coupling patch is a rectangle, an opening of the U-shaped groove is set to face a long side of the microstrip coupling patch, to improve a transfer effect of the coupling apparatus. It should be understood that the opening of the U-shaped groove may further face a short side of the microstrip coupling patch, and may be specifically set according to a use requirement. Details are not described herein again.

In a possible implementation, when the PCB and the waveguide in the coupling apparatus provided in this application are connected, the coupling apparatus further includes a connection portion. The connection portion includes a first connection surface formed on a side that is of the waveguide and that faces the PCB, and the connection portion further includes a second connection surface formed on a side that is of the PCB and that faces the waveguide. The PCB is fastened to the waveguide by welding the first connection surface and the second connection surface. In another possible implementation, the waveguide may be fastened to the PCB through a screw and a fastener, and in a connection manner like bonding.

When the waveguide is connected to the PCB through welding, to prevent solder from entering the waveguide cavity during a welding operation, the waveguide may be provided with a material blocking structure. For example, it may be set that the material blocking structure includes an isolation rib structure. It should be noted that a surface that is of the isolation rib structure and that faces the PCB abuts against the PCB. It should be understood that the isolation rib structure is closely attached to the PCB, so that the waveguide can be well attached to the PCB. However, because solder between the first connection surface and the second connection surface has a specific thickness, the isolation rib structure exceeds the first connection surface, and the isolation rib structure may be used to prevent an overflow from the first connection surface and the second connection surface from entering the waveguide cavity. There are a plurality of implementations when the isolation rib structure is specifically disposed. In a possible implementation, the isolation rib structure is disposed around the waveguide cavity. In another possible implementation, the isolation rib structure is disposed on only an outer side of the waveguide cavity. In other words, the isolation rib structure may be discontinuously disposed, or may be disposed on only a side of the waveguide cavity.

In addition, it may be set that the material blocking structure includes an overflow groove that is set in the waveguide. Specifically, the overflow groove is on a side that is of the isolation rib structure that is away from the waveguide cavity, and an opening of the overflow groove faces the PCB. The overflow groove is configured to store an overflow formed by solder that is painted on the first connection surface and the second connection surface during extrusion, for example, overflowed tin, to reduce a possibility that the overflow enters the waveguide cavity.

When the coupling apparatus provided in this application is specifically disposed, the PCB may be further provided with an auxiliary material blocking structure, to improve a transfer effect of the coupling apparatus. Specifically, a position of the overflow groove corresponding to the PCB may be provided with the auxiliary material blocking structure, so that a vertical projection of the overflow groove on the PCB covers a vertical projection of the auxiliary material blocking structure on the PCB. It should be understood that, the overflow groove can reduce a possibility that an overflow enters the waveguide cavity from the waveguide, and the auxiliary material blocking structure can prevent solder from overflowing to the waveguide cavity through the PCB. Therefore, the auxiliary material blocking structure cooperates with the overflow groove to better prevent an overflow from entering the waveguide cavity. This better improves a transfer effect of the coupling apparatus provided in this application. For example, the auxiliary material blocking structure may be a groove formed in the PCB or solder mask. Certainly, when the auxiliary material blocking structure is the groove formed in the PCB, an opening of the groove faces the waveguide.

According to a second aspect, this application provides a waveguide antenna. The waveguide antenna includes the coupling apparatus in any technical solution provided in the first aspect. The coupling apparatus in the waveguide antenna is easy to manufacture and has excellent transfer performance.

According to a third aspect, this application provides a radar. The radar includes the waveguide antenna in the technical solution provided in the second aspect. The coupling apparatus in the waveguide antenna of the radar is easy to manufacture and has excellent transfer performance.

According to a fourth aspect, this application provides a terminal. The terminal includes the radar in the technical solution provided in the second aspect. The terminal can save costs, is easy to manufacture, and has excellent transfer performance Further, the terminal may be an intelligent transportation device (for example, a vehicle, an uncrewed aerial vehicle, or a robot), a smart home device, an intelligent wearable device, an intelligent manufacturing device, or the like.

According to a fifth aspect, this application provides a PCB. The PCB has at least one switching area, and a microstrip coupling patch is disposed in each switching area. It should be understood that the switching area on the PCB is configured to cooperate with a coupling port of a waveguide, to implement conversion of an electromagnetic signal between the PCB and the waveguide. Specifically, when an electromagnetic signal on the PCB is transmitted, through a microstrip, to the microstrip coupling patch connected to the microstrip, the microstrip coupling patch is coupled to the coupling port of the waveguide through the microstrip coupling patch and a coupling gap, to convert the electromagnetic signal into an electromagnetic signal that can be transmitted in the waveguide. On the contrary, an electromagnetic signal in the waveguide may be converted into an electromagnetic signal that can be transmitted in the microstrip in the switching area.

The PCB provided in this application couples energy with the waveguide by using the microstrip coupling patch, to implement energy transmission between the PCB and the waveguide, so as to remove a back cavity structure, and simplify a manufacturing process. In addition, the microstrip coupling patch is provided with the coupling gap, so that transfer performance of the coupling apparatus can be improved and bandwidth can be expanded.

When the PCB provided in this application is specifically disposed, an impedance transition section may be further disposed in the switching area. The impedance transition section is connected to the microstrip coupling patch in the switching area and the microstrip on the PCB, to adjust impedance during energy transmission between the PCB and the waveguide. For example, the impedance transition section is transitionally connected to the microstrip coupling patch and the microstrip. It should be understood that the impedance transition section may be disposed in each switching area, or the impedance transition section may be disposed in only some switching areas.

For example, when the coupling gap on each microstrip coupling patch is specifically set, the coupling gap may be set to a U-shaped groove. Certainly, the coupling gap may also be H-shaped, straight-shaped, or a triangle, and may be specifically set according to a use requirement. Details are not described herein again.

According to a sixth aspect, this application provides a manufacturing method of a coupling apparatus. The manufacturing method of the coupling apparatus includes:
providing at least one switching area on a surface of a PCB, disposing a microstrip coupling patch with a coupling gap in each switching area, and etching a microstrip on the surface of the PCB by using an etching process, to enable the microstrip to be connected to the microstrip coupling patch; and
communicating a coupling port in a waveguide cavity in a waveguide with the switching area that is on the PCB and that corresponds to the coupling port, to enable an overlapping area to exist between a vertical projection of each coupling port on the PCB and the switching area corresponding to the coupling port, and enable the vertical projection of each coupling port on the PCB to cover the microstrip coupling patch in the switching area corresponding to the coupling port.

It should be understood that the manufacturing method of the coupling apparatus provided in this application has simple steps, is easy to operate, and can reduce manufacturing costs. In addition, in the coupling apparatus manufactured by using the manufacturing method provided in this application, the coupling port of the waveguide cooperates with the switching area on the PCB, to implement conversion of an electromagnetic signal between the PCB and the waveguide. In addition, the microstrip coupling patch is provided with the coupling gap, so that transfer performance of the coupling apparatus can be improved and bandwidth can be expanded.

### BRIEF DESCRIPTION OF DRAWINGS

FIG. 1 is a structural diagram of a waveguide antenna and a radar applied to a coupling apparatus according to an embodiment of this application;
FIG. 2 is a schematic diagram of a structure of a coupling apparatus in the conventional technology;
FIG. 3 is a schematic diagram of a structure of a coupling apparatus according to an embodiment of this application;
FIG. 4 is an enlarged schematic diagram of a structure of an area M observed along a direction a in FIG. 3;
FIG. 5 is a schematic diagram of a structure of a PCB in FIG. 4;
FIG. 6 is a schematic diagram of a structure of a waveguide in FIG. 5;
FIG. 7 is a sectional view at a plane P in FIG. 3;
FIG. 8 is a simulation model of a coupling apparatus according to an embodiment of this application;
FIG. 9 is a diagram of a simulation result of a structure in FIG. 8;
FIG. 10 is a flowchart of a manufacturing method of a coupling apparatus according to an embodiment of this application; and
FIG. 11 is a schematic diagram of a structure of a terminal according to an embodiment of this application.

### DESCRIPTION OF EMBODIMENTS

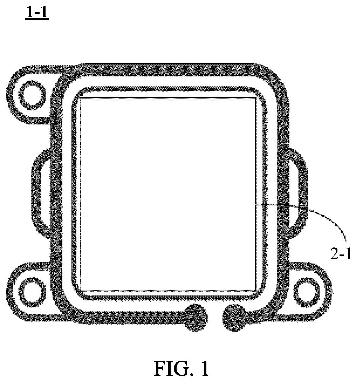

To facilitate understanding of a coupling apparatus provided in embodiments of this application, an application scenario of the coupling apparatus is first described. A coupling apparatus 100 provided in this embodiment of this application may be applied to a waveguide antenna 2-1 of a radar 1-1. For example, as shown in FIG. 1, the waveguide antenna 2-1 is disposed in the radar 1-1, and one or more coupling apparatuses 100 provided in this embodiment of this application are disposed in the waveguide antenna 2-1. The coupling apparatus 100 herein is configured to transfer energy between a waveguide and a PCB. It should be understood that the coupling apparatus in FIG. 1 is disposed in the waveguide antenna 2-1, and therefore is not shown. Certainly, as shown in FIG. 1, this embodiment of this application further provides the waveguide antenna 2-1 to which the coupling apparatus provided in this embodiment of this application is applied and the radar 1-1 to which the waveguide antenna 2-1 is applied.

Specifically, a chip in the radar 1-1 emits an electromagnetic signal through a microstrip at a pin, and the electromagnetic signal passes through the coupling apparatus between the waveguide and the PCB. The coupling apparatus converts the electromagnetic signal in the microstrip into an electromagnetic signal that can be transmitted in the waveguide. The electromagnetic signal is propagated in the waveguide, and is radiated to space through the waveguide antenna 2-1. Conversely, the waveguide antenna 2-1 converts an electromagnetic wave that is freely radiated in space into the electromagnetic signal that can be transmitted in the waveguide. Then, the electromagnetic signal in the waveguide passes through the energy transfer coupling apparatus between the waveguide and the PCB, and is converted into an electromagnetic signal that can be transmitted in the microstrip. Finally, a received signal is transmitted to the chip in the radar 1-1 through the pin of the chip.

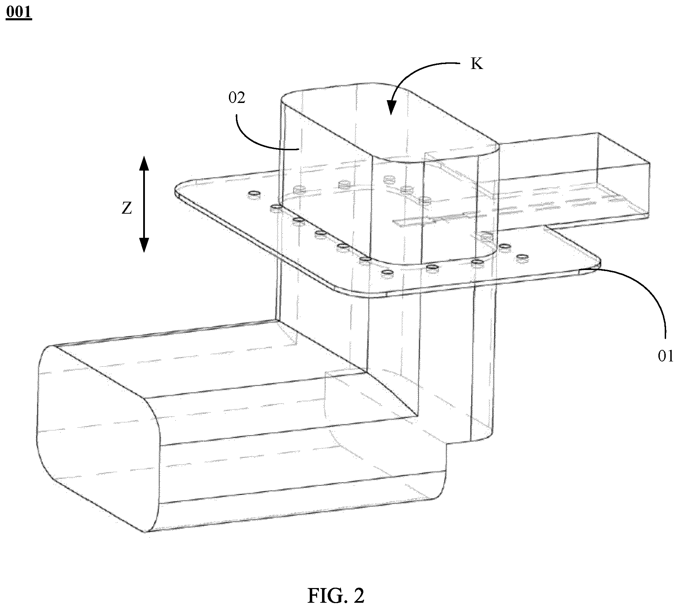

FIG. 2 is a schematic diagram of a structure of an existing coupling apparatus 001 for implementing a function of energy transfer between a waveguide and a PCB. In a structure shown in FIG. 2, there is a metal cavity structure 02 on a side of a pattern area of a PCB 01, and the metal cavity structure 02 provides a short-circuit surface K for energy transmission of the PCB 01. However, the metal cavity structure 02 makes a size of the entire coupling apparatus along a direction Z larger, so that processing is difficult and processing costs are increased.

In the conventional technology, there is another coupling apparatus 001 that can implement a function of energy transfer between a waveguide and a PCB. The coupling apparatus 001 implements energy transmission between the waveguide and the PCB through transfer by using a conventional PCB pattern. However, in a solution in which a PCB pattern is used for transfer, bandwidth is narrow, and transfer performance is average.

Based on this, an embodiment of this application provides a coupling apparatus, and the coupling apparatus is easy to manufacture and has excellent transfer performance.

Terms used in the following embodiments are merely intended to describe specific embodiments, but are not intended to limit this application. Terms "one", "a" and "this" of singular forms used in this specification and the appended claims of this application are also intended to include expressions such as "one or more", unless otherwise specified in the context clearly. Terms "include", "contain", "have", and variants thereof all mean "including, but not limited to", unless otherwise specifically emphasized in another manner.

The following clearly and completely describes the technical solutions in embodiments of this application with reference to the accompanying drawings in embodiments of this application.

First, that an electromagnetic signal transmitted in a microstrip in this embodiment of this application is a quasi-TEM wave (Transverse Electromagnetic Wave) is described. The TEM wave is called a transverse electromagnetic wave, which means that both an electric field and a magnetic field are perpendicular to a propagation direction. An electromagnetic signal transmitted in a waveguide is a TE₁₀ wave. A TE wave (Transverse Electric Wave) is called a transverse wave, which means that an electric field direction is perpendicular to a propagation direction. It should be noted that the TE₁₀ wave is a most important mode in a rectangular waveguide, and this mode has a fixed and stable polarization direction.

In a coupling apparatus provided in this application, the coupling apparatus may include a PCB and a waveguide. The PCB has at least one switching area, a microstrip coupling patch is disposed in each switching area, and each microstrip coupling patch is provided with a coupling gap. The PCB is further provided with a microstrip, and each microstrip coupling patch is connected to the microstrip. The waveguide has a waveguide cavity, and the waveguide cavity includes a coupling port corresponding to the switching area. An overlapping area exists between a vertical projection of each coupling port on the PCB and the switching area corresponding to the coupling port, and the vertical projection of each coupling port on the PCB covers the microstrip coupling patch in the switching area corresponding to the coupling port.

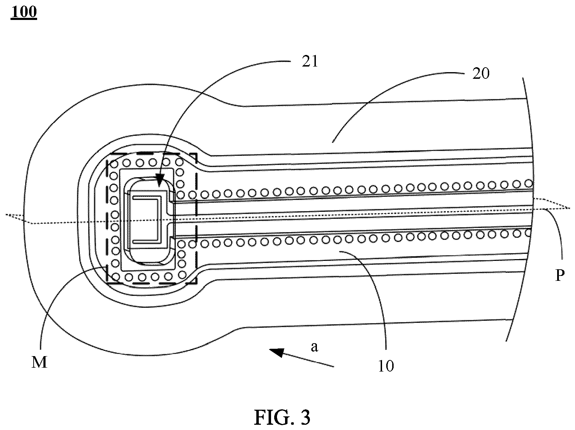

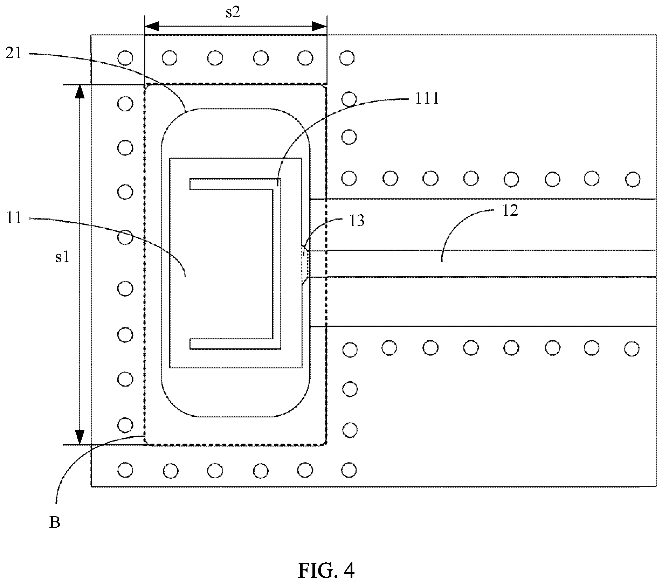

Details are shown in FIG. 3 and FIG. 4. FIG. 3 is a schematic diagram of a structure of a coupling apparatus 100 according to an embodiment of this application. FIG. 4 is an enlarged schematic diagram of a structure of an area M observed along a direction a in FIG. 3. Refer to the structure shown in FIG. 4 with reference to FIG. 3. The coupling apparatus 100 includes a PCB 10 and a waveguide 20. A microstrip coupling patch 11 and a microstrip 12 are formed on the PCB 10, and the microstrip coupling patch 11 is provided with a coupling gap 111. It should be understood that a shape of the microstrip coupling patch 11 herein is a rectangle. Certainly, the microstrip coupling patch 11 may be set to another shape according to a requirement. Details are not described herein again. Specifically, the microstrip 12 is connected to the microstrip coupling patch 11, and the microstrip coupling patch 11 is disposed in a switching area B. The microstrip coupling patch 11 performs energy transfer between an electromagnetic signal on the PCB 10 and an electromagnetic signal in the waveguide 20 through the coupling gap 111 at a wide edge. It should be understood that the PCB 10 may be provided with a plurality of switching areas B for implementing energy transfer. During specific setting, the microstrip coupling patch 11 may be disposed in each switching area B, to implement a transfer function of the switching area B.

Still refer to the structure shown in FIG. 4 with reference to FIG. 3. The waveguide 20 has a waveguide cavity 21, and the waveguide cavity 21 includes a coupling port 211 that corresponds to the switching area B and that is configured to implement an electromagnetic signal conversion function. A vertical projection of the coupling port 211 on the PCB 10 is in the switching area B, and a vertical projection of each coupling port 211 on the PCB 10 covers the microstrip coupling patch 11 in the switching area B. It should be noted that, because of a manufacturing process or a device layout requirement, the vertical projection of the coupling port 211 on the PCB 10 may be partially outside the switching area B. Therefore, when the coupling apparatus 100 provided in this embodiment of this application is manufactured, only an overlapping area between the vertical projection of the coupling port 211 on the PCB 10 and the switching area B needs to be met.

In the coupling apparatus 100 provided in this embodiment of this application, the microstrip coupling patch 11 couples energy, to implement energy transfer between the PCB 10 and the waveguide 20. The microstrip coupling patch 11 is provided with the coupling gap 111, so that transfer performance of the coupling apparatus 100 provided in this embodiment of this application can be improved and bandwidth can be expanded. In addition, compared with the conventional technology, a metal back cavity structure is removed from the coupling apparatus, so that the coupling apparatus 100 provided in this embodiment of this application has an advantage of good sizes in various directions, and a manufacturing process can be simplified.

For ease of understanding of the coupling apparatus 100 provided in this embodiment of this application, the following first specifically describes a signal processing procedure.

Still refer to FIG. 3 and FIG. 4. When an electromagnetic signal on the PCB 10 is transmitted through the microstrip 12 to the microstrip coupling patch 11 connected to the microstrip 12, the microstrip coupling patch 11 is coupled to the coupling port 211 through the microstrip coupling patch 11 and the coupling gap 111, to convert the electromagnetic signal into an electromagnetic signal that can be transmitted in the waveguide cavity 21 of in waveguide 20. Then, the converted electromagnetic signal is transmitted in the waveguide cavity 21, and is radiated to space through the waveguide 20. On the contrary, the electromagnetic signal in the waveguide cavity 21 may be converted, in the switching area B, into an electromagnetic signal that can be transmitted in the microstrip 12, and then the converted electromagnetic signal is transmitted in the microstrip 12.

During specific implementation, the PCB 10 may be disposed as a structure in which a dielectric layer is below a surface pattern, and a lower layer of the dielectric layer is a bottom plate. The structure can reduce a thickness of the coupling apparatus 100 provided in this embodiment of this application. For example, a thickness of the PCB 10 is a thickness of a carbide (NF30) plate in the radar 1-1 shown in FIG. 1, and is about 0.2 mm. It should be noted that a structure of the PCB 10 of the coupling apparatus 100 in any one of the following solutions is further protected in this application.

Specifically, still refer to the structure shown in FIG. 4. An impedance transition section 13 may be further disposed in the switching area B on the PCB 10 in the coupling apparatus 100 provided in this embodiment of this application. The impedance transition section 13 is connected to the microstrip coupling patch 11 and the microstrip 12, and is configured to adjust impedance during energy transfer between the PCB 10 and the waveguide 20. For example, the impedance transition section 13 is transitionally connected to the microstrip coupling patch 11 and the microstrip 12. It should be understood that, to clearly show a structure of the impedance transition section 13, a dashed line is used for schematic separation in FIG. 4, but a specific structure of the impedance transition section 13 is not limited to a portion in the dashed line in FIG. 4. Certainly, during specific setting, it may be set that the impedance transition section 13 is disposed in each switching area B, or it may be set that the impedance transition section 13 is disposed in only some switching areas B.

During specific application, to improve a capability of an alignment tolerance between the PCB 10 and the waveguide 20 in the coupling apparatus 100 provided in this embodiment of this application, it may be set that a vertical projection of each coupling port 211 on the PCB 10 is in the switching area B corresponding to the coupling port 211.

In other words, a size of the switching area B is greater than a size of the coupling port 211, to reduce an impact of an alignment error on transfer performance. For example, a length s1 of the switching area B is λ, and a width s2 is 0.5 λ. A size of the switching area B is greater than a size of the coupling port 211. Here, λ is a wavelength of a signal propagated on the PCB 10. In another possible scenario, λ may alternatively be a wavelength of a signal propagated in air or another medium.

In addition, during specific implementation, specific structure types of the coupling gap 111 may also be diversified.

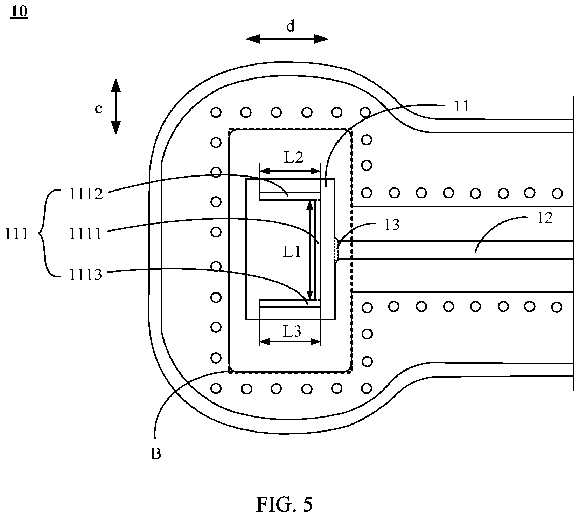

For example, as shown in FIG. 5, in an embodiment provided in this application, the coupling gap 111 is a U-shaped groove. The coupling gap 111 can improve transfer performance of the coupling apparatus 100 provided in this embodiment of this application.

Certainly, the coupling gap 111 may also be H-shaped, straight-shaped, or a triangle, and may be specifically set according to a use requirement. Details are not described herein again. In actual use, parameter adjustment and optimization may be performed based on different shapes of the coupling gap 111, so that the coupling apparatus 100 provided in this embodiment of this application has different transfer effects.

Still refer to FIG. 5. The microstrip coupling patch 11 may be a rectangle. Correspondingly, the coupling port 211 corresponding to the microstrip coupling patch 11 may be a rectangular waveguide port. A model of the coupling port 211 may be selected as a WR 12 standard waveguide port. Certainly, the coupling port 211 may also be selected as another model according to a requirement, and details are not described herein again.

When the microstrip coupling patch 11 is rectangular, and the coupling gap 111 is the U-shaped groove shown in FIG. 5, a width of the coupling gap 111 may be set to 0.06 mm to 0.1 λ, where λ is a wavelength of a signal propagated on the PCB 10. Similarly, in another possible scenario, λ may also be a wavelength of a signal propagated in air or another medium. An opening of the U-shaped groove faces a long side of the microstrip coupling patch 11. It should be understood that the opening of the U-shaped groove may further face a short side of the microstrip coupling patch 11, and may be specifically set according to a use requirement. Details are not described herein again.

During specific setting, the coupling gap 111 shown in FIG. 5 may include a bottom 1111, a first extension portion 1112, and a second extension portion 1113. The first extension portion 1112 and the second extension portion 1113 are set opposite to each other and are on a same side of the bottom 1111. It should be understood that, to clearly show structures of the first extension portion 1112 and the second extension portion 1113, a dashed line is used for schematic separation herein. However, specific structures of the first extension portion 1112 and the second extension portion 1113 are not limited to portions in the dashed line in FIG. 5.

A range of a size of each part in the coupling gap 111 may be set as follows: along an arrangement direction (a direction c in FIG. 5) of the first extension portion 1112 and the second extension portion 1113, a size L1 of the bottom 1111 is 0.5 λ to 1.5 λ. Similarly, λ herein is a wavelength of a signal propagated on the PCB 10. Similarly, in another possible scenario, λ may alternatively be a wavelength of a signal propagated in air or another medium. Along a direction d, a range of a size L2 of the first extension portion 1112 is 0.2 λ to 0.8 λ, and a range of a size L3 of the second extension portion 1113 is 0.2 λ to 0.8 λ. It should be noted that the direction d is perpendicular to the direction c in FIG. 5. It should be understood that lengths of the first extension portion 1112 and the second extension portion 1113 may be the same as or different from those shown in FIG. 5, and the bottom 1111 may be parallel to the long side of the microstrip coupling patch 11 like the structure shown in FIG. 5, to improve a transfer effect. Certainly, the bottom 1111 may not be parallel to the long side of the microstrip coupling patch 11, and may be specifically set according to a requirement. Details are not described herein again.

A size design of the coupling gap 111 shown in FIG. 5 is provided. A width of the coupling gap 111 is 0.05 λ, L1 is 0.75 λ, and both L2 and L3 are 0.4 λ.

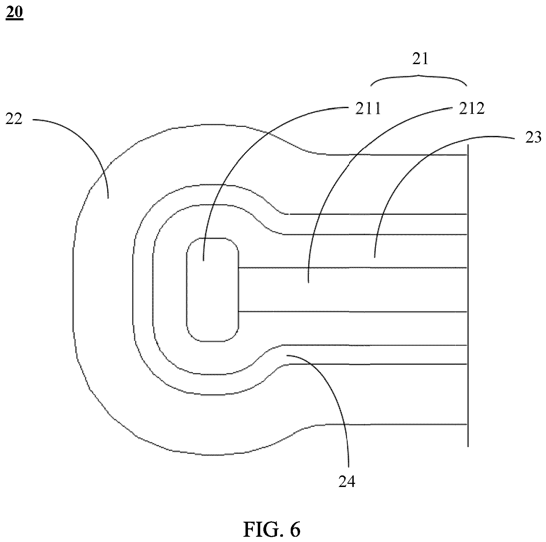

FIG. 6 is a schematic diagram of a specific structure of the waveguide 20 in FIG. 5. It should be noted that the waveguide 20 has a waveguide cavity 21, and in addition to a coupling port 211 for implementing an energy transfer function, the waveguide cavity 21 further includes another waveguide cavity portion 212 connected to the coupling port 211.

It should be noted that when the waveguide 20 provided in this embodiment of this application is fastened to the PCB 10, the waveguide 20 may be fastened to the PCB 10 through welding. It may be understood that, in another implementation, in the coupling apparatus 100 provided in this embodiment of this application, the waveguide 20 may alternatively be fastened to the PCB 10 in another manner. For example, the waveguide 20 may be fastened to the PCB 10 through a screw and a fastener, and in a connection manner like bonding. Details are not described herein again.

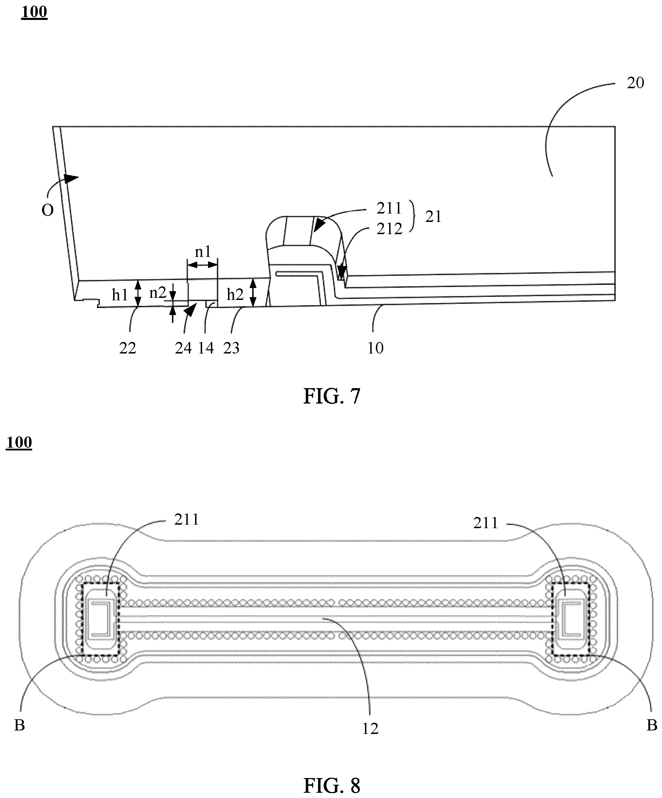

For example, as shown in FIG. 6 and FIG. 7, when the waveguide 20 and the PCB 10 in the coupling apparatus 100 provided in this embodiment of this application are connected through welding, the coupling apparatus 100 further includes a connection portion. The connection portion includes a first connection surface 22 formed on a side that is of the waveguide 20 and that faces the PCB 10, and the connection portion further includes a second connection surface (not shown in the figure due to an angle reason) formed on a side that is of the PCB 10 and that faces the waveguide 20. The PCB 10 is fastened to the waveguide 20 by welding the first connection surface 22 and the second connection surface.

Certainly, to prevent solder from entering the waveguide cavity 21 during a welding operation, the waveguide 20 may be provided with a material blocking structure. For example, it may be set that the material blocking structure includes an isolation rib structure 23.

There are a plurality of implementations when the isolation rib structure 23 is specifically disposed. In a possible implementation, the isolation rib structure 23 is disposed around the waveguide cavity 21, and details are shown in FIG. 7. In another possible implementation, the isolation rib structure 23 is disposed on only outer sides of some waveguide cavities 21. In other words, the isolation rib structure 23 may be discontinuously disposed, or may be disposed on only a side of the waveguide cavity 21.

It should be noted that a surface that is of the isolation rib structure 23 and that faces the PCB 10 abuts against the PCB 10. It should be understood that the isolation rib structure 23 is closely attached to the PCB 10, so that the waveguide 20 can be well attached to the PCB 10. However, because solder between the first connection surface 22 and the second connection surface has a specific thickness, the isolation rib structure 23 exceeds the first connection surface 22, and the isolation rib structure 23 may be used to prevent an overflow from the first connection surface 22 and the second connection surface from entering the waveguide cavity 21.

To more clearly explain a height relationship between the isolation rib structure 23 and the first connection surface 22, as shown in FIG. 7, a surface O that is of the waveguide 20 and that is opposite to the first connection surface 22 is used as a reference surface, a height from the first connection surface 22 to the reference surface O is h1, a size from the isolation rib structure 23 to the reference surface O is h2, and h2 is greater than h1. For example, a difference between h2 and h1 is 0.1 mm. Certainly, another size difference may also be set according to a requirement, and details are not described herein again.

In addition, to further improve a tin blocking effect, a tin blocking structure may further include an overflow groove 24 that is set in the waveguide 20. Specifically, the overflow groove 24 is disposed on a side that is of the isolation rib structure 23 and that is away from the waveguide cavity 21, and an opening of the overflow groove 24 faces the PCB 10.

The overflow groove 24 cooperates with the isolation rib structure 23. The overflow groove 24 is configured to store an overflow during extrusion, for example, overflowed tin. The isolation rib structure 23 is configured to further block the overflow in the overflow groove 24. In an embodiment provided in this application, for example, in the structure shown in FIG. 7, a width n1 of the overflow groove 24 is 0.6 mm, and a depth n2 is 0.3 mm.

Certainly, the PCB 10 may be further provided with an auxiliary material blocking structure, to improve a transfer effect of the coupling apparatus 100, so that the coupling apparatus 100 has good engineering implementability and connection performance. In the structure shown in FIG. 7, a position of the overflow groove 24 corresponding to the PCB 10 may be provided with an auxiliary material blocking structure 14, so that a vertical projection of the overflow groove 24 on the PCB 10 covers a vertical projection of the auxiliary material blocking structure 14 on the PCB.

It should be understood that, the overflow groove 24 can reduce a possibility that an overflow enters the waveguide cavity 21 from the waveguide 20, and the auxiliary material blocking structure 14 can prevent an overflow from overflowing to the waveguide 20 through the PCB 10. Therefore, the auxiliary material blocking structure 14 cooperates with the overflow groove 24 to better prevent an overflow from entering the waveguide cavity 21. This better improves a transfer effect of the coupling apparatus 100 provided in this application.

For example, the auxiliary material blocking structure 14 may be a groove formed in the PCB 10 or solder mask. Certainly, when the auxiliary material blocking structure 14 is the groove formed in the PCB 10, an opening of the groove faces the waveguide 20.

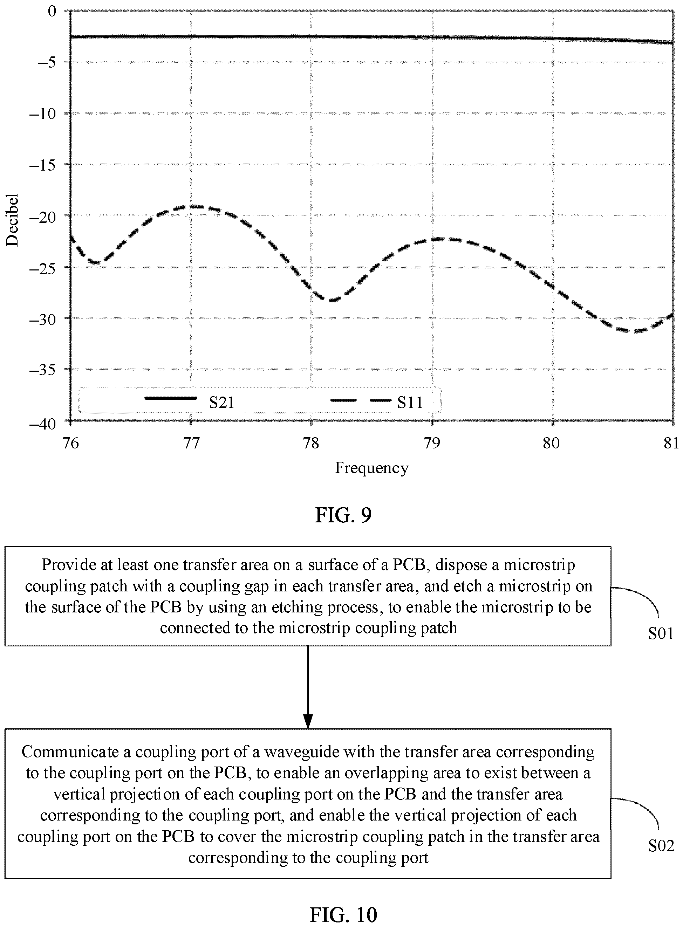

A structure shown in FIG. 8 is a simulation model in which the coupling apparatus 100 provided in an embodiment of this application is used. In the structure shown in FIG. 8, the simulation model has two switching areas B. Correspondingly, two coupling ports 211 form a back-to-back mode, a length of a microstrip 12 is set to 24 mm as an example, and each coupling port 211 is a WR12 standard waveguide port. FIG. 9 is a diagram of a simulation result of the structure in FIG. 8. As shown in FIG. 9, in an E-BAND frequency band within a range of 6% of relative bandwidth, a return loss S11 is less than -19 dB, and an insertion loss S21 is less than 3.2 dB. It can be learned that the coupling apparatus 100 provided in this embodiment of this application has good transfer performance. For a definition of the E-BAND, refer to the conventional technology or comply with industry regulations.

For example, when the coupling apparatus 100 provided in embodiments of this application shown in FIG. 3 and FIG. 4 is manufactured, as shown in FIG. 10, a manufacturing method of the coupling apparatus 100 includes the following steps:

Step S01: Provide at least one switching area B on a surface of a PCB 10, dispose a microstrip coupling patch 11 with a coupling gap 111 in each switching area B, and etch a microstrip 12 on the surface of the PCB 10 by using an etching process, to enable the microstrip 12 to be connected to the microstrip coupling patch 11.

Step S02: Communicate a coupling port 211 in a waveguide cavity 21 in a waveguide 20 with the switching area B corresponding to the coupling port 211 on the PCB 10, to enable an overlapping area to exist between a vertical projection of each coupling port 211 on the PCB 10 and the switching area B corresponding to the coupling port 211, and enable the vertical projection of each coupling port 211 on the PCB 10 to cover the microstrip coupling patch 11 in the switching area B corresponding to the coupling port 211.

It should be understood that the manufacturing method of the coupling apparatus provided in this application has simple steps, is easy to operate, and can reduce manufacturing costs. In addition, in the coupling apparatus 100 manufactured by using the manufacturing method provided in this application, the coupling port 211 of the waveguide 20 cooperates with the switching area B on the PCB 10, to implement conversion of an electromagnetic signal between the PCB 10 and the waveguide 20. In addition, the microstrip coupling patch 11 is provided with the coupling gap 111, so that transfer performance of the coupling apparatus 100 can be improved and bandwidth can be expanded.

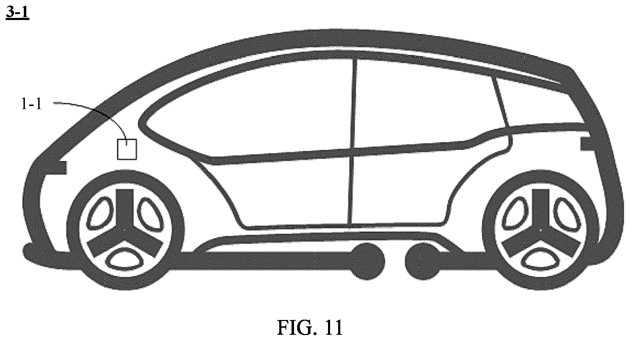

In addition, an embodiment of this application further protects a terminal. For example, a terminal 3-1 is a vehicle shown in FIG. 11. Still refer to a structure shown in FIG. 11. The terminal 3-1 is provided with a radar 1-1, and the coupling apparatus 100 in the radar 1-1 is easy to manufacture and has excellent transfer performance. It should be understood that, in this case, the radar 1-1 is used as a vehicle-mounted radar, and a position of the radar 1-1 is not limited to a position shown in FIG. 11. Details are not described herein again.

Certainly, the terminal provided in this embodiment of this application is not limited to the structure of the vehicle shown in FIG. 11, and may be another structure of a terminal in which the radar 1-1 is installed. For example, the terminal may be terminal devices such as intelligent transportation, intelligent manufacturing, an uncrewed aerial vehicle, a robot, and smart home. Specifically, for example, a vehicle and a surveying and mapping device.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to a protection scope of the claims.

## Claims

1. A coupling apparatus (100) comprising a printed circuit board PCB (10) and a waveguide (20), wherein
the PCB (10) has at least one switching area (B), a microstrip coupling patch (11) is disposed in each switching area (B), each microstrip coupling patch (11) is provided with a coupling gap (111), the PCB (10) is further provided with a microstrip (12), and each microstrip coupling patch (11) is connected to the microstrip (12); and
the waveguide (20) has a waveguide cavity (21), the waveguide cavity (21) comprises a coupling port (211) corresponding to the switching area (B), an overlapping area exists between a vertical projection of each coupling port (211) on the PCB (10) and the switching area (B) corresponding to the coupling port (211), the vertical projection of each coupling port (211) on the PCB (10) covers the microstrip coupling patch (11) in the switching area (B) corresponding to the coupling port (211).

2. The coupling apparatus (100) according to claim 1, wherein an impedance transition section (13) is further disposed in the switching area (B), and the microstrip coupling patch (11) in the switching area (B) is connected to the microstrip (12) through the impedance transition section (13).

3. The coupling apparatus (100) according to claim 1 or 2, wherein the vertical projection of each coupling port (211) on the PCB (10) is in the switching area (B) corresponding to the coupling port (211).

4. The coupling apparatus (100) according to any one of claims 1 to 3, wherein the coupling gap (111) is a U-shaped groove.

5. The coupling apparatus (100) according to claim 4, wherein a shape of the microstrip coupling patch (11) is a rectangle, and an opening of the U-shaped groove faces a long side of the microstrip coupling patch (11).

6. The coupling apparatus (100) according to any one of claims 1 to 5, wherein the waveguide (20) is further provided with a material blocking structure, the material blocking structure comprises an isolation rib structure (23), and a surface that is of the isolation rib structure (23) and that faces the PCB (10) abuts against the PCB (10).

7. The coupling apparatus (100) according to claim 6, wherein the material blocking structure further comprises an overflow groove (24), the overflow groove (24) is on a side that is of the isolation rib structure (23) and that is away from the waveguide cavity (21), and an opening of the overflow groove (24) faces the PCB (10).

8. The coupling apparatus (100) according to claim 7, wherein the PCB (10) is further provided with an auxiliary material blocking structure, and a vertical projection of the overflow groove (24) on the PCB (10) covers a vertical projection of the auxiliary material blocking structure on the PCB (10).

9. The coupling apparatus (100) according to any one of claims 1 to 8, wherein the coupling apparatus comprises a connection portion, the connection portion comprises a first connection surface (22) formed on a side that is of the waveguide (20) and that faces the PCB (10), the connection portion further comprises a second connection surface formed on a side that is of the PCB (10) and that faces the waveguide (20), and the second connection surface is welded to the first connection surface (22).

10. A waveguide antenna (2-1), comprising the coupling apparatus (100) according to any one of claims 1 to 9.

11. A radar (1-1), comprising the waveguide antenna (2-1) according to claim 10.

12. A terminal (3-1), comprising the radar (1-1) according to claim 11.

13. A PCB (10), comprising a PCB (10) body, wherein the PCB (10) body has at least one switching area (B) for transferring energy with a waveguide (20), a microstrip coupling patch (11) is disposed in each switching area (B), each microstrip coupling patch (11) is provided with a coupling gap (111), the PCB (10) body is further provided with a microstrip (12), and each microstrip coupling patch (11) is connected to the microstrip (12).

14. The PCB (10) according to claim 13, wherein an impedance transition section (13) is further disposed in the switching area (B), and the microstrip coupling patch (11) in the switching area (B) is connected to the microstrip (12) through the impedance transition section (13).

15. The PCB (10) according to claim 13 or 14, wherein the coupling gap (111) is a U-shaped groove.

16. A manufacturing method of a coupling apparatus (100), comprising:
providing at least one switching area (B) on a surface of a PCB (10), disposing a microstrip coupling patch (11) with a coupling gap (111) in each switching area (B), and etching a microstrip (12) on the surface of the PCB (10) by using an etching process, to enable the microstrip (12) to be connected to the microstrip coupling patch (11); and
communicating a coupling port (211) in a waveguide cavity (21) in a waveguide (20) with the switching area (B) corresponding to the coupling port (211) on the PCB (10), to enable an overlapping area to exist between a vertical projection of each coupling port (211) on the PCB (10) and the switching area (B) corresponding to the coupling port (211), and enable the vertical projection of each coupling port (211) on the PCB (10) to cover the microstrip coupling patch (11) in the switching area (B) corresponding to the coupling port (211).
